# EUROPEAN PATENT APPLICATION

(11) **EP 2 876 531 A1**
(43) Date of publication of application: **27.05.2015**
(21) Application number: 13830735.0
(22) Date of filing: 23.01.2013
(51) Int. Cl.: G06F 3/044

(54) **NON-OVERLAPPED INTEGRAL CAPACITIVE TOUCH SCREEN WITH ITO (INDIUM TIN OXIDE) LAYER AND MANUFACTURING METHOD THEREOF**

(30) Priority: 21.08.2012 CN 201210298943
(71) Applicant: Shenzhen Baoming Technology Ltd, Guangdong 518000 (CN)
(72) Inventor: CAO, Xiaoxing, Shenzhen Guangdong 518000 (CN)
(74) Representative: Sun, Yiming
(86) International application number: PCT/CN2013/070862
(87) International publication number: WO 2014/029200

(57) **Abstract**

Disclosed are a non-overlapped integral capacitive touch screen with an ITO (indium tin oxide) layer and the manufacturing method thereof. The non-overlapped integral capacitive touch screen with the ITO layer comprises a transparent substrate, and a silicon dioxide layer, a niobium pentoxide layer, a black resin layer, ITO electrodes and an insulating layer sequentially laminated on the transparent substrate. The silicon dioxide layer convers the transparent substrate completely, and the niobium pentoxide layer covers the silicon dioxide layer completely. The ITO electrodes are horizontally or vertically conductive electrodes having regular graphic structures. The ITO electrodes include the first ITO conductive electrode and the second ITO conductive electrode, and the first ITO conductive electrode and the second ITO conductive electrode are positioned on the same plane, independent and insulated mutually and are staggered. The transparent substrate comprises a windowing region and a non-windowing region, and the black resin layer covers the non-windowing region of a display screen. Since the laminated structure of the capacitive touch screen is designed reasonably, transmittance of the capacitive touch screen is improved effectively, visibility of ITO graphics is lowered, and reliability of the touch screen is improved further.

## Description

### Field of Invention

The present invention relates to the technological field of capacitive touch screen, more particularly to a capacitive touch screen designed with an ITO (indium tin oxide) layer had non-overlapped integral structure and manufacturing method thereof.

### Background of Invention

With the development of electronic technology, keyboards or mice once used in mobile phone, digital camera, handheld game player, vehicle DVD player, MP3 and instrument and apparatus have been gradually replaced by touch screens. Just years ago, touch screens were not so popular in the market. However, with the increasing number of consumers who use the products, touch screens began to be accepted by more people and the related technology grows faster than ever. The speedy growth of touch screen products not only spark fiercer competition in the industry, but also indirectly promote the upgrading of the related technologies. Especially, the operation mode of multi-point control spreads the influence of touch screens in the market to a higher dimension, and attracts more attention from people.

Basically, a touch screen consists of two parts-detector and controller. The former, installed in front of the monitor screen, is used to detect the position of user's touch and send the signals to the latter, while the latter accepts the signals from the detector, converts them into coordinates of the contacting point and then send them to CPU. In the meantime, the controller also receives commands from CPU and executes them.

According to the operating principle of touch screen and the medium that transmits signals, touch screens fall into four categories: resistive type, capacitive induction type, infrared type and SAW (surface acoustic wave) type. The resistive touch screen, most widely used so far, performs resistance control by taking the advantage of the forced induction. A resistive touch screen is a multi-layer composite film, whose main part is the resistive film panel perfectly matching the monitor. The resistive film panel uses a glass or hard plastic panel as its substrate, the surface of which is coated with a conductive layer -the transparent oxide metal (transparent conductive resistor) ITO (indium tin oxide). Covered on the surface of the conductive layer is a smooth and scratch-proof plastic layer that has undergone hardening treatment, the internal surface of which is also coated with an ITO layer. Between the two ITO layers are a great number of small transparent isolation spots (size less than 1/1000 inch) that isolate the two ITO layers. Once the user's finger touches the screen, the isolation spots will be contacting each other, while the resistance will change and signals will be generated at both direction X and Y. These signals are then transmitted to the controller that detects this contact and computes the locations of X and Y. After that, the system will operate like a simulated mouse.

A capacitive touch screen works by making use of the current induction on human body, which comprises of two composite glass panels. Coated on the internal surface of the glass panel is a conductive film-the ITO layer, while its external surface is coated with protective thin silicon dioxide layer layer. The ITP layer functions as a working face, whose four corners lead out four electrodes. Once the user's finger touches the screen, because of the human electric field, a coupling capacitance will be formed between the user and the surface of touch screen. As for high-frequency current, the capacitance will serve as a direct conductor. Thus, the user's finger absorbs from the contact a very low current which comes from the four corners of the touch screen respectively and is in direct proportion to the distance between the finger and the four corners. The controller will tell the location of contact through precise computation of the four current ratios.

Among the capacitive touch screens, the most widely used is the projected capacitive touch screen, which features its simple structure and high light transmittance. The touch-sensing part of a projected capacitive touch screen is an induction matrix structured by interlacing multiple row and column electrodes. Normally, in designing the touch screen, the row and column electrodes are respectively set at the two sides of the same transparent substrate, so as to avoid short circuit at the interlacing positions, or they are set at the same side of one transparent substrate and stand on the same the conductive film (often ITO conductive film). In the second structure, insulation layer and conducting bridge are used at the interlacing locations of the electrodes, so that the row electrodes and column electrodes are separated from each other to ensure conductivity for their respective direction. In this way, short circuit can be prevented at the positions of interlacing.

In normal designing, one type of the electrodes (either row or column electrodes) is continuously set on the conductive film, while the other forms several electrode blocks on the conductive film after partitioned by the continuously set electrodes. At the interlacing positions the neighboring electrodes are connected through the conductive bridge, thus forming continuous electrodes in the other direction. The conductive bridge and the continuously set electrodes are separated by the insulation layer, so that short circuit can be prevented at the interlacing positions of the row or column electrodes. The commonly used designed scheme is: (1) The laminated structure sequentially consists of transparent substrate, first direction electrode, insulation layer and conducting bridge; or (2) The laminated structure sequentially consists of transparent substrate, conducting bridge, insulation layer and first direction electrode.

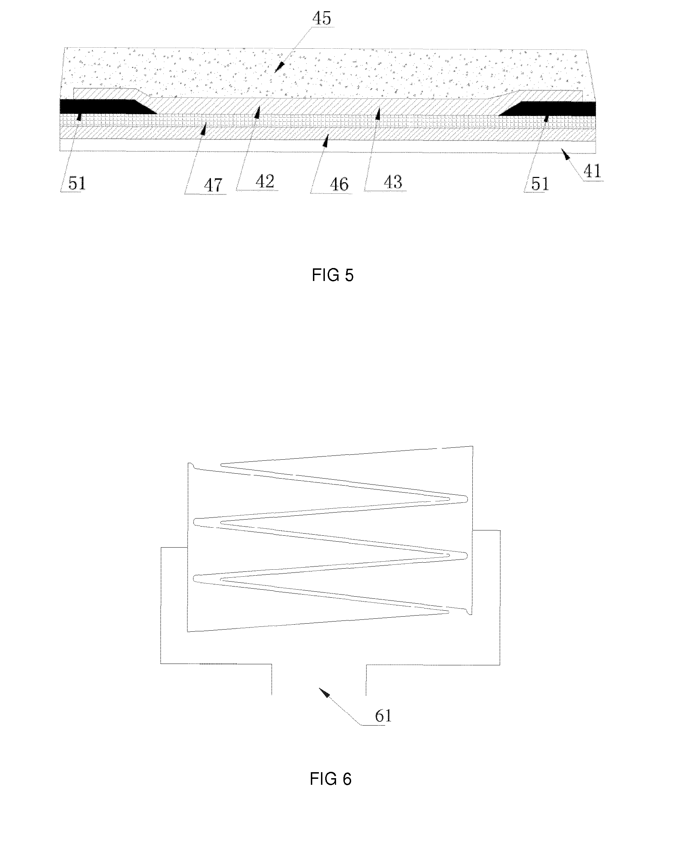

None metal layer non-overlapped integral capacitive touch screen's design, the right and left electrode extracted the fixed plate state position of flexible line respectively, as shown in Figure 6, of which 61 is shown in position location for the state. Because only had horizontal electrode, without vertical electrode ; each horizontal electrode lead from right and left, and then lead to the bonding position around the electrode; the right and left electrode mutually insulated and independent each other, without any bridge and through hole. Because only had the horizontal electrode, capacitor was formed between the horizontal electrode and the ground line, by changing the capacitance value to detect the location of the touch, can only achieve a single touch and gesture recognition.

In capacitive touch screen with conventional design such defects as lower light transmittance and poor operating stability always exist. Conventional design seldom offers light transmittance higher than 80%. Besides, when the whole structure deforms because of abnormal force, the interface will be detached, which may result in ineffective touch because of the open circuit of electrode, and in damage of the touch sensor.

### Summary of Invention

The first object of the present invention is to provide A non-overlapped integral capacitive touch screen with an ITO (indium tin oxide) layer. Through improved design with its laminated structure and conduction, the transmittance of the touch screen can be efficiently improved, visuality of ITO pattern lowered and reliability of the touch screen enhanced.

To achieve the aforesaid object, the present invention will adopt the technical scheme below:
A non-overlapped integral capacitive touch screen with an ITO (indium tin oxide) layer, whereas, comprises a transparent substrate, and a silicon dioxide layer, a niobium pentoxide layer, a black resin layer, ITO electrodes and an insulating layer sequentially laminated on the transparent substrate; the silicon dioxide layer covers the transparent substrate completely, and the niobium pentoxide layer covers the silicon dioxide layer completely; the ITO electrodes are horizontally or vertically conductive electrodes having regular graphic structures; the ITO electrodes include the first ITO conductive electrode and the second ITO conductive electrode, and the first ITO conductive electrode and the second ITO conductive electrode are positioned on the same plane, independent and insulated mutually and are staggered; the transparent substrate comprises a windowing region and a non-windowing region, and the black resin layer covers the non-windowing region of a display screen; the said silicon dioxide layer is 100-1000 ANG in thickness, while niobium pentoxide layer is 50-500 ANG.

A non-overlapped integral capacitive touch screen with an ITO (indium tin oxide) layer, whereas, comprises a black resin layer, a transparent substrate, and a silicon dioxide layer, a niobium pentoxide layer, ITO electrodes and an insulating layer sequentially laminated on the transparent substrate; the silicon dioxide layer covers the transparent substrate completely, and the niobium pentoxide layer covers the silicon dioxide layer completely; the ITO electrodes are horizontally or vertically conductive electrodes having regular graphic structures; the ITO electrodes include the first ITO conductive electrode and the second ITO conductive electrode, and the first ITO conductive electrode and the second ITO conductive electrode are positioned on the same plane, independent and insulated mutually and are staggered; the transparent substrate comprises a windowing region and a non-windowing region, and the black resin layer covers the non-windowing region of a display screen; the said silicon dioxide layer is 100-1000 ANG in thickness, while niobium pentoxide layer is 50-500 ANG.

The structure and production process of the non-overlapped integral capacitive touch screen with an ITO (indium tin oxide) layer were simplified, reduced the bridge needed and lapped the traditional integrated capacitive screen or through hole technology, reduced production cost and shorten production process time. ITO layer of non overlapping integral touch screen can realize the touch mode for the same lap type integral (bridge mode and the through hole like way), and can realize multi-point touch (more than two) and gesture recognition. Without the metal layer non over lapping integral touch screen can only achieve a single touch and gesture recognition. ITO layer of non overlapping integral touch screen only a layer of ITO electrode, can realize the multi touch and gesture recognition, the touch effect with the traditional two layer glass mutual capacitance touch the same effect, and its cost is lower than the traditional two layers of glass mutual capacitance touch screen.

ITO layer of non overlapping one touch screen with the horizontal direction (driving electrode) and the vertical direction (induction electrode) electrode; driving electrode into several from the vertical direction out, induction electrode is led out from the upper and lower, and then leads to bonding position, the left and right border area without any wire electrode and the electrode are mutually vertical level; insulation and independence, a driving electrode and a sensing electrode without any bridge or a through hole; a sensing electrode corresponding with a plurality of driving electrodes. Because the mutual capacitance exist horizontal electrode (driving electrode) and vertical electrode (induction electrode), a parasitic capacitance between the two, to detect touch through the parasitic capacitance value change position, and can realize multi-point (more than two) touch and gesture recognition.

Non overlapping integral capacitance touch screen because had none metal electrode, the maximum value of ITO guided through electrode surface resistance is far less than then overlapping integral ITO touch screen surface resistance.

The optimized selections for this model are as follows: The said transparent substrate is made of chemically tempered glass, or resin, with thickness of 0.5-2.0mm, and the said ITO electrode is structured as regularly patterned triangle-type, bar-type, or oval-shaped.

The black-resin section is structured as trapezoid, with thickness of 0.3µm∼5µm in its middle and a bevel angle of 6-60 degrees at the edge. Such a gentle angle is designed in an attempt to prevent the ITO electrode from breaking in the case of the sharp thickness difference appearing when ITO electrodes (drive wire ITO electrode 1 and induction wire ITO electrode 2) pass by the slope. The black resin area serves as the non-window section of the display screen to shade the metal electrode.

The insulation layer protection ITO electrode and made the air insulation.

The said black resin is made of protective light-sensitive photoresist (KE410 made by Taiwan Everlight Chemical). As a black negative photoresist, the material mainly consists of: acryl resin, epoxy resin, negative light-sensitive agent, propylene glyool monomethyl ether acetate(PMA) and black pigment, the actual ratio of which are as follows: 15∼30(resin):60∼80(PMA):1∼10(black pigment and negative light-sensitive agent).

Formation of ITO crossover electrode: Use ITO to coat the black resin-coated transparent substrate and make a transparent ITO film with even thickness of 50-2000ANG on the substrate (surface resistance 10-430 ohm);

The second object of the present invention is to provide a manufacturing method of the non-overlapped integral capacitive touch screen with an ITO (indium tin oxide) layer, including:
Formation of silicon dioxide layer: Coat the transparent substrate with SiO₂ to form a transparent SiO₂ film with even thickness of 100-1000 ANG;
Formation of niobium pentoxide layer: Coat the silicon dioxide layer layer with Nb₂O₅ to form a transparent Nb₂O₅ film with even thickness of 50-500 ANG;
Formation of black resin layer:
   First the black resin is evenly spread to the transparent substrate by spin-coating or blade-coating, with thickness of 0.3µm∼5µm. Then the resin is pre-baked, exposed and developed to create the needed black-resin section. The black-resin section is structured as trapezoid, with thickness of 0.3µm∼5µm in its middle and a bevel angle of 6-60 degrees at the edge. Such a gentle angle is designed in an attempt to prevent the ITO electrode from breaking in the case of the sharp thickness difference appearing when ITO electrodes (drive wire ITO electrode 1 and induction wire ITO electrode 2) pass by the slope. The black resin area serves as the non-window section of the display screen to shade the metal electrode. The said black resin is made of protective light-sensitive photoresist (KE410 made by Taiwan Everlight Chemical). As a black negative photoresist, the material mainly consists of: acryl resin, epoxy resin, negative light-sensitive agent, propylene glyool monomethyl ether acetate(PMA) and black pigment, the actual ratio of which are as follows: 15∼30(resin):60∼80(PMA):1~10(black pigment and negative light-sensitive agent).
Formation of ITO electrode: Use ITO to coat the black resin-coated transparent substrate and make a transparent ITO film with even thickness of 80-2000ANG on the substrate (surface resistance 10-270 ohm);
   Coat a layer of positive photoresist on the ITO-coated transparent substrate, with even thickness of 1 µm∼5µm;
   After the photoresist is pre-baked, exposed, developed, etched and released, and finally a 80-2000ANG-thick layer of photoresist (surface resistance 10-270 ohm) and the regular ITO pattern or electrode will be formed.
   the ITO electrodes are horizontally or vertically conductive electrodes having regular graphic structures; the ITO electrodes include the first ITO conductive electrode and the second ITO conductive electrode, and the first ITO conductive electrode and the second ITO conductive electrode are positioned on the same plane, independent and insulated mutually and are staggered.
Formation of insulation layer:
   Coat a layer of negative photoresist on the ITO-coated transparent substrate, with even thickness of 0.5µm∼3µm;
   After the photoresist is pre-baked, exposed and developed, the insulation layer pattern with thickness of 0.5∼3µm layer and regular insulation layer were formed.

The said ITO electrode is made of In₂O₃ and SnO₂, whose mass ratio is 85-95:5-15. ITO coating can be performed through the means below: vacuum magnetic-enhanced sputtering, chemical vapor phase depositing, thermal evaporating and sol-gel method.

The said positive photresist materials are mainly made up of propylene glyool monomethyl ether acetate, epoxy resin and positive light-sensitive agent (TR400 made by Taiwan Xinyingcai Co.); the negative photresist materials are mainly made up of propylene glyool monomethyl ether acetate, acryl resin, epoxy resin and negative light-sensitive agent (POC A46 made by Taiwan Daxing Co.). The photoresist can be coated to the substrate by roll coating, spin coating, blade coating or other ways.

Anther manufacturing method of the non-overlapped integral capacitive touch screen with an ITO (indium tin oxide) layer, including:
Formation of black resin layer:
   First the black resin is evenly spread to the transparent substrate by spin-coating or blade-coating, with thickness of 0.3µm∼5µm. Then the resin is pre-baked, exposed and developed to create the needed black-resin section.
Formation of silicon dioxide layer: Coat the transparent substrate with SiO₂ to form a transparent SiO₂ film with even thickness of 100-1000 ANG;
Formation of niobium pentoxide layer: Coat the silicon dioxide layer layer with Nb₂O₅ to form a transparent Nb₂O₅ film with even thickness of 50-500 ANG;
Formation of ITO electrode: Use ITO to coat the black resin-coated transparent substrate and make a transparent ITO film with even thickness of 80-2000ANG on the substrate (surface resistance 10-270 ohm);
Coat a layer of positive photoresist on the ITO-coated transparent substrate, with even thickness of 1 µm∼5µm;
After the photoresist is pre-baked, exposed, developed, etched and released, and finally a 80-2000ANG-thick layer of photoresist (surface resistance 10-270 ohm) and the regular ITO pattern or electrode will be formed.

The ITO electrodes are horizontally or vertically conductive electrodes having regular graphic structures; the ITO electrodes include the first ITO conductive electrode and the second ITO conductive electrode, and the first ITO conductive electrode and the second ITO conductive electrode are positioned on the same plane, independent and insulated mutually and are staggered.
Formation of insulation layer:
   Coat a layer of negative photoresist on the ITO-coated transparent substrate, with even thickness of 0.5µm∼3µm;
   After the photoresist is pre-baked, exposed and developed, the insulation layer pattern with thickness of 0.5∼3µm layer and regular insulation layer were formed.

Compared with the prior art, the present invention features its advantages and effects below:
Through improved design of the laminated structure, the touch screen signal electrode and black-resin covering layer can be formed on the transparent substrate, lowering costs and improving products' reliability. Substrate with thickness of 0.5mm∼2.0mm in the present invention offers such advantages as thin structure and light mass. The improved design for all layers also features its higher transmittance of capacitive touch screen and lower visuality of ITO pattern, thus enhancing the reliability of touch screen.

The structure and production process of the non-overlapped integral capacitive touch screen with an ITO (indium tin oxide) layer were simplified, reduced the metal electrode, reduced production cost and shorten production process time. ITO layer of non overlapping integral touch screen can realize multi-point touch (more than two) and gesture recognition. Without the metal layer non over lapping integral touch screen can only achieve a single touch and gesture recognition.

### Drawings for the present invention

Fig. 1 Structural Diagram of Capacitive Touch screen;
Fig.2 Structure Diagram of Glass Substrate
Fig. 3 Enlarged Structural Diagram of Design
Fig. 4 Sectional View of Design
Fig.5 Sectional View of non-overlapped integral capacitive touch screen
Fig. 6 Structural Diagram of none metal layer capacitive touch screen

### Detailed description of preferred embodiments of the invention

In the following parts are further descriptions of the present invention with reference to the preferred embodiments.

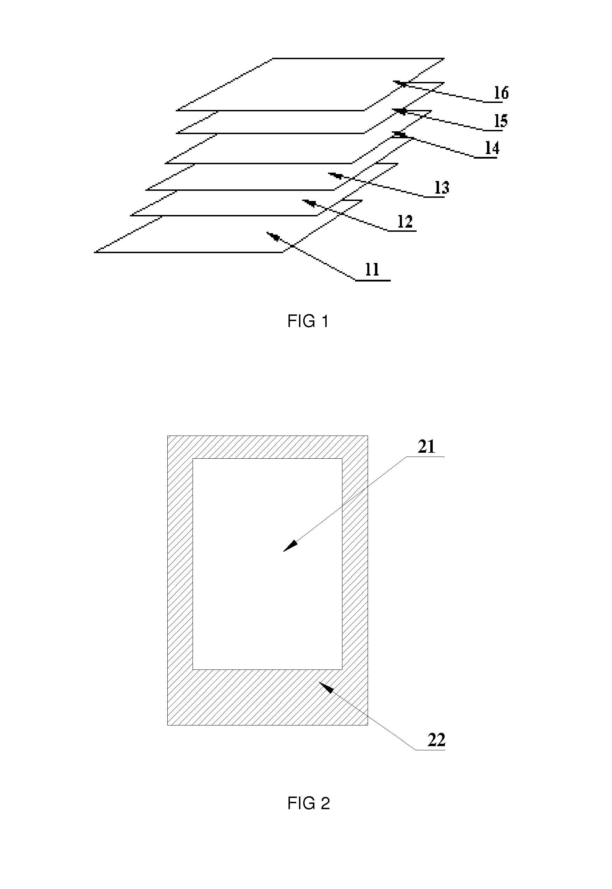

As shown in Fig. 1 and 2, the said non-overlapped integral capacitive touch screen comprises of the chemically tempered glass substrate or resin substrate (thickness 0.5mm∼2.0mm) 11, and of the silicon dioxide layer layer12, niobium pentoxide layer13, black resin layer14, ITO crossover electrode15, insulation layer16, the ITO electrodes include the first ITO conductive electrode and the second ITO conductive electrode, and the first ITO conductive electrode and the second ITO conductive electrode are positioned on the same plane, independent and insulated mutually and are staggered.

The said transparent substrate comprises of window section 21 and non-window section 22, with the black resin arranged in the non-window section 22 of the display screen.

The said black resin layer can shade not only the graphics layer of non-window section, but also the light and the visible things under the metal wire.

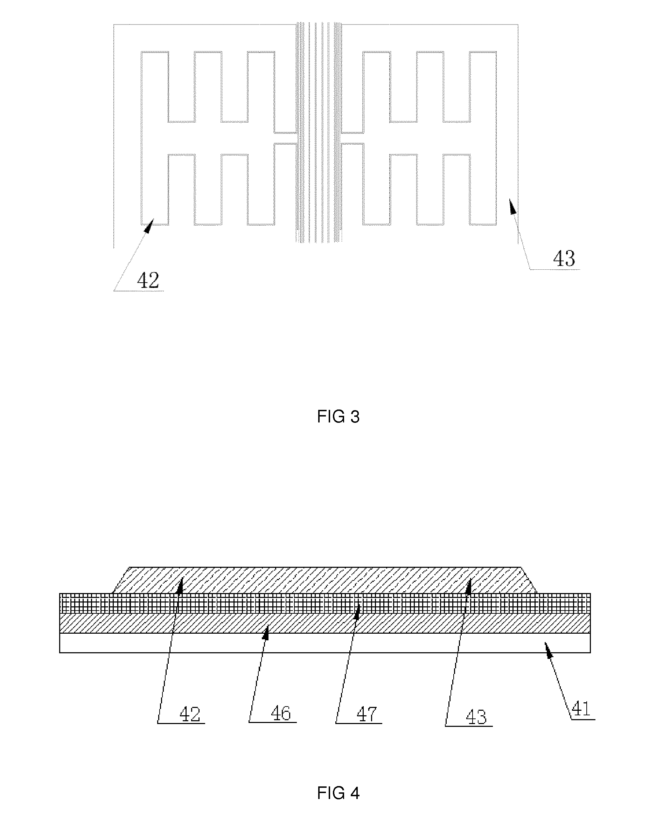

Fig.3-5 are the enlarged diagram for local structure of and sectional view of the said ITO crossover capacitive touch screen of the preferred embodiment: ITO electrode13 includes the first electrode 42and the second electrode 43. insulation layer45 protect ITO electrode 42 and ITO electrode 43 insulated from air.

### Manufacturing process:

Formation of silicon dioxide layer layer: Coat the transparent substrate with SiO₂ to form a transparent SiO₂ film with even thickness of 0, 50, 100, 300, 400, 700, 1000 or 1500 ANG;

Formation of niobium pentoxide layer: Coat the silicon dioxide layer layer with Nb₂O₅ to form a transparent Nb₂O₅ film with even thickness of 0, 20, 50, 150, 200, 400, 500 or 1000ANG;

First black resin is evenly spread to the transparent substrate 41(11) by spin-coating or blade-coating, with thickness of 0.3µm∼5µm. Then the resin is pre-baked, exposed and developed to create the needed black-resin section. The black-resin section is structured as trapezoid, with thickness of 0.3µm∼5µm in its middle and a bevel angle of 6-60 degrees at the edge. Such a gentle angle is designed in an attempt to prevent the ITO electrode from breaking in the case of the sharp thickness difference when ITO electrodes (the first ITO electrode and the second ITO electrode) pass by the slope. The black resin area serves as the non-window section of the display screen to shade the metal electrode. The said black resin is made of protective light-sensitive photoresist (KE410 made by Taiwan Everlight Chemical). As a black negative photoresist, the material mainly consists of: acryl resin, epoxy resin, negative light-sensitive agent, propylene glyool monomethyl ether acetate(PMA) and black pigment, the actual ratio of which are as follows: 15∼30(resin):60∼80(PMA):1~10(black pigment and negative light-sensitive agent).

In forming the black resin layer, the pre-baking temperature is set as 60-150 °C, time as 50-200 seconds and exposure energy as 100-500mj. Na series or Ka series alkaline solution is used as developer, and developing temperature is set as 20-40 °C. Then the black resin is hard baked under the temperature of 200-300 °Cand for 0.5-3 hours. After the above processes, a black resin layer 51 with regular pattern and thickness of 0.3µm∼5µm will be finally formed.

Formation of ITO crossover electrode: After the transparent glass substrate is chemically tempered, it will be ITO coated to make a transparent ITO film with even thickness of 80-2000ANG (surface resistance 10-270 ohm); the said ITO electrode is made of In₂O₃ and SnO₂, whose mass ratio is 85-95:5-15. ITO coating can be performed through the means below: vacuum magnetic-enhanced sputtering, chemical vapor phase depositing, thermal evaporating and sol-gel method.

Coat a layer of positive photoresist on the ITO-coated transparent substrate, with even thickness of 1µm∼5µm; the said positive photresist materials are mainly made up of propylene glyool monomethyl ether acetate, epoxy resin and positive light-sensitive material. The photoresist can be coated to the substrate by roll coating, spin coating, blade coating or other ways.

After the above processes, the photoresist will be pre-baked, exposed, developed, etched and released, and finally a 80-2000ANG-thick layer of photoresist (surface resistance 10-270ohm) and the regular ITO pattern or electrode will be formed. In forming the layer, the pre-baking temperature is set as 60-150 °C, time as 50-200 seconds and exposure energy as 100-500mj. Na series or Ka series alkaline solution is used as developer, and the developing temperature is set as 20-40 °C. Hydrochloric acid and nitric acid are mixed by a certain proportion to make the ITO etching solution, with PH value as 1-3. The etching temperature is set as 40-50°C. Dimethylsulfoxide and cholamine are mixed under a proportion of 70%:30% to make the liquid to release the photoresist, with release temperature of 40-80°C.

The ITO electrodes are horizontally or vertically conductive electrodes having regular graphic structures; the ITO electrodes include the first ITO conductive electrode and the second ITO conductive electrode, and the first ITO conductive electrode and the second ITO conductive electrode are positioned on the same plane, independent and insulated mutually and are staggered.

Formation of insulation layer:
Coat a layer of negative photoresist on the ITO-coated transparent substrate, with even thickness of 0.5µm∼3µm; the negative photresist materials are mainly made up of propylene glyool monomethyl ether acetate, acryl resin, epoxy resin and negative light-sensitive agent. The photoresist can be coated to the substrate by roll coating, spin coating, blade coating or other ways.

After the above processes, the photoresist will be pre-baked, exposed and developed, and finally the regularly patterned insulation layer with thickness of 0.5∼3µm will be formed. In forming layer, the pre-baking temperature is set as 60-150 °C, time as 50-200 seconds and exposure energy as 100-500mj. Na series or Ka series alkaline solution is used as developer, and developing temperature is set as 20-40 °C. Then the insulation layer is hard baked under the temperature of 200-300 °Cand for 0.5-3 hours. After the above processes, insulation layer with regular pattern and thickness of 0.5µm∼3µm will be finally formed.

With the upgrading of consumers' taste, in the case of electronic products, more emphasis is shifted to their quality. For single-body touch screen, consumers all the more stress its high tranmittance, low reflectivity, invisibility of ITO pattern and high reliability. Thus higher requirements are proposed to us in designing the single-body touch screen.

In the present invention, due to the adoption of SiO₂ and Nb₂O₅, which are properly arranged on the substrate to make an optimized thickness, the touch screen remarkably raises its transmittance and lowers the visuality of the pattern. Especially, when the thickness of SiO₂ is set as 100-1000ANG and Nb₂O₅ as 50-500ANG, the transmittance of the product can be maintained as 93% or higher, and visuality controlled within Class 2, claiming a perfect effect. (Visuality classes are defined as follows: Class 0: completely unseen; Class 10: obviously seen. The higher the class is, the higher the visuality will be)

SiO₂ features its anti-reflection and background-pattern reduction functions. For lights with different polarization states offer phases and amplitudes when reflected on film and air different from those when on film and lining interface, SiO₂ can change the polarization state, lower product reflectivity and reduce visuality of pattern after film reflection. With the increase of the SiO₂ film, some anti-reflection effect can be produced due to the film's interference. Ordinary glass can offer a reflectivity of about 5%, while glass coated with SiO₂ can offer a reflectivity of about 2%. People's naked eyes can obviously see the ITO pattern on the glass with such pattern from a viewing angle, but can't obviously see the ITO pattern on SiO₂-coated glass with such pattern.

If the films are laminated in the following order-black resin, SiO₂and Nb₂O₅, the manufacturing process can be adjusted as:
Formation of black-resin film: Coat the black resin on the transparent substrate through spin or blade process, with even thickness of 0.3µm∼5µm, and pre-bake, expose and develop the resin to form the black-resin section;
Formation of silicon dioxide layer layer: Coat SiO₂ on the black resin film to form a transparent silicon dioxide layer layer, with even thickness of 100-1000ANG; Formation of Nb₂O₅ layer: Coat Nb₂O₅ on the silicon dioxide layer layer to form a transparent Nb₂O₅layer, with even thickness of 50-500ANG;
   Not many changes are needed for other processes.

The above descriptions constitute further information provided with reference with the detailed execution scheme of the present invention, but it shall not be considered that the execution of the present invention be limited to these contents. For regular technical personnel in the field of the invention, inductions or replacements are deemed to be within the protected scope of the present invention, so long as they don't break away from original conception.

## Claims

1. A non-overlapped integral capacitive touch screen with an ITO (indium tin oxide) layer, whereas, comprises a transparent substrate, and a silicon dioxide layer, a niobium pentoxide layer, a black resin layer, ITO electrodes and an insulating layer sequentially laminated on the transparent substrate; the silicon dioxide layer covers the transparent substrate completely, and the niobium pentoxide layer covers the silicon dioxide layer completely; the ITO electrodes are horizontally or vertically conductive electrodes having regular graphic structures; the ITO electrodes include the first ITO conductive electrode and the second ITO conductive electrode, and the first ITO conductive electrode and the second ITO conductive electrode are positioned on the same plane, independent and insulated mutually and are staggered; the transparent substrate comprises a windowing region and a non-windowing region, and the black resin layer covers the non-windowing region of a display screen; the said silicon dioxide layer is 100-1000 ANG in thickness, while niobium pentoxide layer is 50-500 ANG.

2. A non-overlapped integral capacitive touch screen with an ITO (indium tin oxide) layer, whereas, comprises a black resin layer, a transparent substrate, and a silicon dioxide layer, a niobium pentoxide layer, ITO electrodes and an insulating layer sequentially laminated on the transparent substrate; the silicon dioxide layer covers the transparent substrate completely, and the niobium pentoxide layer covers the silicon dioxide layer completely; the ITO electrodes are horizontally or vertically conductive electrodes having regular graphic structures; the ITO electrodes include the first ITO conductive electrode and the second ITO conductive electrode, and the first ITO conductive electrode and the second ITO conductive electrode are positioned on the same plane, independent and insulated mutually and are staggered; the transparent substrate comprises a windowing region and a non-windowing region, and the black resin layer covers the non-windowing region of a display screen; the said silicon dioxide layer is 100-1000 ANG in thickness, while niobium pentoxide layer is 50-500 ANG.

3. As claim 1 or claim 2 said touch screen, whereas, the said transparent substrate is made of chemically tempered glass, or resin, with thickness of 0.5-2.0mm, and the said ITO electrode is structured as regularly patterned includes bar-type, or caterpillar-type, mutual independence and mutual insulation each other.

4. As claim3 said touch screen ,whereas, The said black resin layer is 0.3µm ∼ 5µm in thickness, the ITO crossover electrode layer is 80-2000 ANG in thickness.

5. As claim 4 said touch screen ,whereas, the said ITO layer including In₂O₃ and SnO₂, the mass ratio is 95-98:2-5.

6. A manufacturing method of the non-overlapped integral capacitive touch screen with an ITO (indium tin oxide) layer, including:
Formation of silicon dioxide layer: Coat the transparent substrate with SiO₂ to form a transparent SiO₂ film with even thickness of 100-1000 ANG;
Formation of niobium pentoxide layer: Coat the silicon dioxide layer layer with Nb₂O₅ to form a transparent Nb₂O₅ film with even thickness of 50-500 ANG;
Formation of black resin layer: First the black resin is evenly spread to the transparent substrate by spin-coating or blade-coating, with thickness of 0.3µm∼5µm,
then the resin is pre-baked, exposed and developed to create the needed black-resin section;
The said black resin is made of protective light-sensitive photoresist (KE410 made by Taiwan Everlight Chemical). As a black negative photoresist, the material mainly consists of: acryl resin, epoxy resin, negative light-sensitive agent, propylene glyool monomethyl ether acetate(PMA) and black pigment, the actual ratio of which are as follows: 15∼30(resin):60∼80(PMA):1∼10(black pigment and negative light-sensitive agent);
Formation of ITO crossover electrode: Use ITO to coat the black resin-coated transparent substrate and make a transparent ITO film with even thickness of 80-2000ANG on the substrate;
Coat a layer of positive photoresist on the ITO-coated transparent substrate, with even thickness of 1 µm∼5µm;
After the photoresist is pre-baked, exposed, developed, etched and released, and finally a 80-2000ANG-thick layer and the regular ITO pattern or electrode was formed;
The said ITO electrodes the ITO electrodes include are horizontally or vertically conductive electrodes having regular graphic structures; the ITO electrodes include the first ITO conductive electrode and the second ITO conductive electrode, and the first ITO conductive electrode and the second ITO conductive electrode are positioned on the same plane, independent and insulated mutually and are staggered;
Formation of insulation layer:
Coat a layer of negative photoresist on the metal film of the transparent substrate, with even thickness of 0.5µm∼3µm;
After the photoresist is pre-baked, exposed and developed, the insulation layer pattern with thickness of 0.5∼3µm was formed.

7. A manufacturing method of the non-overlapped integral capacitive touch screen with an ITO (indium tin oxide) layer, including:
Formation of black resin layer: First the black resin is evenly spread to the transparent substrate by spin-coating or blade-coating, with thickness of 0.3µm∼5µm,
then the resin is pre-baked, exposed and developed to create the needed black-resin section;
The said black resin is made of protective light-sensitive photoresist (KE410 made by Taiwan Everlight Chemical). As a black negative photoresist, the material mainly consists of: acryl resin, epoxy resin, negative light-sensitive agent, propylene glyool monomethyl ether acetate(PMA) and black pigment, the actual ratio of which are as follows: 15∼30(resin):60∼80(PMA):1∼10(black pigment and negative light-sensitive agent);
Formation of silicon dioxide layer: Coat the transparent substrate with SiO₂ to form a transparent SiO₂ film with even thickness of 100-1000 ANG;
Formation of niobium pentoxide layer: Coat the silicon dioxide layer layer with Nb₂O₅ to form a transparent Nb₂O₅ film with even thickness of 50-500 ANG;
Formation of ITO crossover electrode: Use ITO to coat the black resin-coated transparent substrate and make a transparent ITO film with even thickness of 80-2000ANG on the substrate;
Coat a layer of positive photoresist on the ITO-coated transparent substrate, with even thickness of 1µm∼5µm;
After the photoresist is pre-baked, exposed, developed, etched and released, and finally a 80-2000ANG-thick layer and the regular ITO pattern or electrode was formed;
The said ITO electrodes the ITO electrodes include are horizontally or vertically conductive electrodes having regular graphic structures; the ITO electrodes include the first ITO conductive electrode and the second ITO conductive electrode, and the first ITO conductive electrode and the second ITO conductive electrode are positioned on the same plane, independent and insulated mutually and are staggered;
Formation of insulation layer:
Coat a layer of negative photoresist on the metal film of the transparent substrate, with even thickness of 0.5µm∼3µm;
After the photoresist is pre-baked, exposed and developed, the insulation layer pattern with thickness of 0.5∼3µm was formed.

8. As claim 6 or 7 said manufacturing method, whereas, the said transparent substrate is made of chemically tempered glass, with thickness of 0.5-2.0mm, and the said ITO electrode includes In₂O₃ and SnO₂, whose mass ratio is 85-95:5-15.

9. As claim 8 said manufacturing method, whereas, the said positive photresist materials are mainly made up of propylene glyool monomethyl ether acetate, epoxy resin and positive light-sensitive agent; the negative photresist materials are mainly made up of propylene glyool monomethyl ether acetate, acryl resin, epoxy resin and negative light-sensitive agent; the process of coated film that said silicon dioxide, niobium pentoxide, and ITO film were vacuum magnetic-enhanced sputtering, or chemical vapor deposition, or thermal evaporation, or for the sol gel.
